# EUROPÄISCHE PATENTSCHRIFT

(11) **EP 3 178 103 B1**
(45) Veröffentlichungstag und Bekanntmachung des Hinweises auf die Patenterteilung: **31.10.2018**
(21) Anmeldenummer: 15756618.3
(22) Anmeldetag: 26.08.2015
(51) Int. Cl.: H01H 33/42, H01H 33/666

(54) **ANORDNUNG ZUM SCHALTEN VON SCHALTSTRECKEN MITTELS SCHALTGERÄTEN**
ARRANGEMENT FOR SWITCHING CLEARANCES BETWEEN CONTACTS BY MEANS OF SWITCHING DEVICES
SYSTÈME POUR COMMUTER DES INTERRUPTEURS AU MOYEN D'APPAREILS DE COMMUTATION

(30) Priorität: 22.09.2014 DE 102014219089
(43) Veröffentlichungstag der Anmeldung: 14.06.2017
(73) Patentinhaber: Siemens Aktiengesellschaft, 80333 München (DE)
(72) Erfinder: SEWIOLO, Benjamin, 90587 Obermichelbach (DE); ZIROFF, Andreas, 81671 München (DE)
(86) Internationale Anmeldenummer: PCT/EP2015/069492
(87) Internationale Veröffentlichungsnummer: WO 2016/045894

(56) Entgegenhaltungen:
- EP-A1- 1 164 610
- DE-A1- 1 807 587
- DE-C- 678 791
- FR-A5- 2 057 386
- US-A- 3 588 520
- US-A- 3 671 688

## Beschreibung

Die Erfindung betrifft eine Anordnung zum Schalten mittels Schaltgeräten gemäß dem Oberbegriff des Anspruchs 1. Der Einsatz von Schaltern in der Elektrotechnik ist bekannt. Schalter in der Elektronik werden in einem Strom- und Spannungsbereich betrieben, der in der Regel keine besondere Belastung oder Anforderungen an den Schalter stellt.

Demgegenüber werden Schalter in der Mittelspannungstechnik mit unterschiedlichen Aufgaben eingesetzt. Beispielsweise als Leistungsschalter, Lastschalter, Trennschalter, Lasttrennschalter, Erdungsschalter oder Schützschalter. Aufgrund ihres in der Regel komplexeren Aufbaus werden sie auch verallgemeinert als Schaltgeräte bezeichnet.

Dabei gegebene Beanspruchungen sind stromloses Schalten, Schalten von Betriebsströmen, Schalten von Kurzschlussströmen.

Anforderungen bestehen beispielsweise darin, dass im geschlossenen Zustand das Schaltgerät dem Fließen von Betriebs- und Kurzschlussströmen einen möglichst kleinen Widerstand bieten soll. Hingegen muss im geöffneten Zustand die offene Schaltstrecke die an ihr auftretenden Spannungen sicher aushalten.

Es ist auch gefordert, dass alle unter Spannung stehenden Teile bei offenem oder geschlossenem Schaltgerat ausreichend gegen Erde und von Phase zu Phase isoliert sein müssen. Ferner soll das Schaltgerät den Stromkreis bei anstehender Spannung schließen können. Bei Trennern fordert man diese Bedingung, von kleinen Ladeströmen abgesehen, allerdings nur für den stromlosen Zustand. Zudem soll das Schaltgerat den Stromkreis bei fließendem Strom öffnen können (diese Forderung wird für Trenner nicht erhoben).

Auch soll das Schaltgerat möglichst niedrige Schaltüberspannungen verursachen.

Bekannte Schaltgeräte, die diese Anforderungen erfüllen, verwenden Vakuumschaltröhren, wie in der Figur 1 zu erkennen. Diese sind, beispielsweise bei einem Leistungsschalter wie in den Figuren 2 und 3 zu sehen, mit Hilfe von Isolatoren an einem Rahmen befestigt und werden mechanisch mit Hilfe eines Hebels geschaltet.

Dieser mechanische Schaltvorgang lässt aufgrund der hohen mechanischen Beanspruchung laut Datenblatt je nach Modell 10.000-120.000 Schaltspiele zu, wobei die Antriebe nach 10.000 Schaltspielen geölt werden und die Vakuumschaltröhren nach 30.000 Schaltspielen ausgetauscht werden müssen.

Dabei ist der gesamte Antriebsmechanismus mit Auslösern, Hilfsschaltern, Anzeige- und Betätigungseinrichtungen in einem Antriebskasten untergebracht.

Die Einschaltfeder wird elektrisch oder per Hand gespannt. Sie verklinkt nach beendetem Spannvorgang und dient als mechanischer Energiespeicher. Die Kraft vom Antrieb zu den Schalterpolen wird über Schaltstangen übertragen.

Zum Einschalten wird die Einschaltfeder mechanisch vor Ort oder durch Fernbetätigung elektrisch entklinkt. Während des Einschaltvorganges spannt die Einschaltfeder die Ausschalt- bzw. Kontaktdruckfedern. Die jetzt entspannte Einschaltfeder wird automatisch durch den Antriebsmotor oder von Hand wieder gespannt, wobei Letzteres den Nachteil der Anwesenheit einer Person hat, die zudem auch u. U. Gefahren ausgesetzt ist. Alternative Ansätze zur Fernbetätigung von Trennern und Schaltern sind aus der FR 2 057 386 A5, der DE 18 07 587 A1, DE 678 791 C, US 3 588 520 A, EP 1 164 610 A1 oder US 3 671 688 A bekannt, bei denen ohne dauerhafte mechanische Verbindung zum Aktor eine Betätigung bewirkt wird, wobei dies beispielsweise über die Energie von Geschossen oder mittels Energie aus Licht erfolgt.

Die Aufgabe der Erfindung ist es, ein Verfahren und eine Anordnung anzugeben, die die Nachteile der vorgenannten Lösungen überwinden.

Diese Aufgabe wird gelöst durch eine Anordnung zum Schalten von Schaltstrecken mittels Schaltgeräten gemäß den Merkmalen des Anspruchs 1.

Bei der erfindungsgemäßen Anordnung zum Schalten von Schaltstrecken mittels Schaltgeräten wird durch eine Energieübertragung von Hochfrequenzenergie eine Aktorenergie für mindestens eine Vakuumschaltröhre, bereitgestellt.

Durch die Übertragung und Bereitstellung der Hochfrequenzenergie entfällt ein Eingriff von Hand für das Schalten. Ferner ermöglicht und unterstützt diese Lösung, dass sich der Einsatz mechanischer Bauteile und auch mechanischer Vorgänge auf ein Mindestmaß reduziert, so dass ein Verschleiß deutlich reduziert wird. Hinzu kommt, dass Hochfrequenzenergieübertragung mit der Möglichkeit einhergeht, Informationen auf dem gleichen Weg bidirektional zu übertragen.

Dies gilt auch für die Nutzung einer Führung der Wellen bei der hochfrequenten Energieübertragung, bei der hierfür das Schaltgerät mechanisch nicht-leitend über einen dielektrischen Wellenleiter, mit der Hochfrequenzquelle verbunden ist, wobei das Schaltgerät derart ausgestaltet ist, dass es Mittel aufweist, die die übertragene Energie in Aktorenergie konvertieren. Weitere Vorteile liegen neben der Übertragung der Energie (im Fachjargon auch Übertragung der Leistung genannt), die zur Schaltung erforderlich ist, in der Isolierung sowie Stabilisation der Anordnung, wenn es sich um einen dielektrischen Wellenleiter handelt. Ferner kann über den Wellenleiter anfallende Wärme abgeleitet werden.

Eine Alternative, die nicht Teil der beanspruchten Erfindung ist, stellt die Weiterbildung der Anordnung dar, nach der zur Energieübertragung eine Abstrahlung der Hochfrequenzenergie als eine elektromagnetische Welle ohne ein die Wellen führendes Medium, wie beispielsweise einen Wellenleiter, an das Schaltgerät erfolgt, wobei das Schaltgerät derart ausgestaltet ist, dass es Mittel aufweist, die die übertragene Energie in Aktorenergie konvertieren.

Die Anordnung ist derart weitergebildet, dass die Konvertierungsmittel als mindestens eine Gleichrichteranordnung ausgestaltet sind. Daher wird die Transformation der Hochfrequenzenergie in elektrische Größen, die für eine Energiespeicherung geeignet sind, bzw. für elektrisch betriebene Schalter bereitgestellt, bei der der Energieübertragung als Aktoren elektrisch betriebene Schalter, insbesondere Relaisschalter, nachgeschaltet sind.

Werden die Konvertierungsmittel aus zumindest zwei parallelen Gleichrichteranordnungen gebildet, können höhere Hochfrequenz (HF-) Leistungen übertragen werden.

Bei einer bevorzugten Weiterbildung besteht der Wellenleiter aus festem dielektrischen Material, insbesondere Aluminiumoxid, Teflon, HD-PE oder heißgepresstem Siliciumcarbid, wobei je nach Wahl des Materials eine Anpassung an die gegebenen Erfordernisse bzw. Optimierungen ermöglicht werden. Siliciumcarbid trägt beispielsweise mit seiner höheren Wärmeleitfähigkeit zu einer besseren Wärmeableitung der Anordnung bei.

Alternativ oder ergänzend kann die Anordnung derart weitergebildet sein, dass der Wellenleiter aus einem flexiblen mit dielektrischen Flüssigkeiten gefüllten Material gebildet ist. Hierdurch sind beispielsweise geometrische Strukturen bildbar, die wiederrum zur mechanischen und elektrischen Optimierung der Anordnung beitragen können.

Sind zumindest Teile der Elemente der Schaltanordnung mit Sensoren versehen, so können Betriebsinformationen von Teilen der Schaltröhre, beispielsweise dem mechanischen Betätiger, über den Wellenleiter zusätzlich und in Gegenrichtung zur Energieübertragung oder bidirektional übertragen werden. Dies kann zur Servicefreundlichkeit der Schaltröhre beitragen und eine mögliche Störung frühzeitig anzeigen und einen Ausfall möglicherweise verhindern.

Bei einem Verfahren, das nicht Teil der beanspruchten Erfindung ist, zum Schalten von Schaltstrecken mittels Schaltgeräten wird durch eine Energieübertragung von Hochfrequenzenergie eine Aktorenergie für mindestens ein Schaltgerät, insbesondere eine Vakuumschaltröhre, bereitgestellt. Das Verfahren legt durch seine Merkmale die Grundlage zur Entfaltung der Vorteile durch die erfindungsgemäße Anordnung und deren Weiterbildungen.

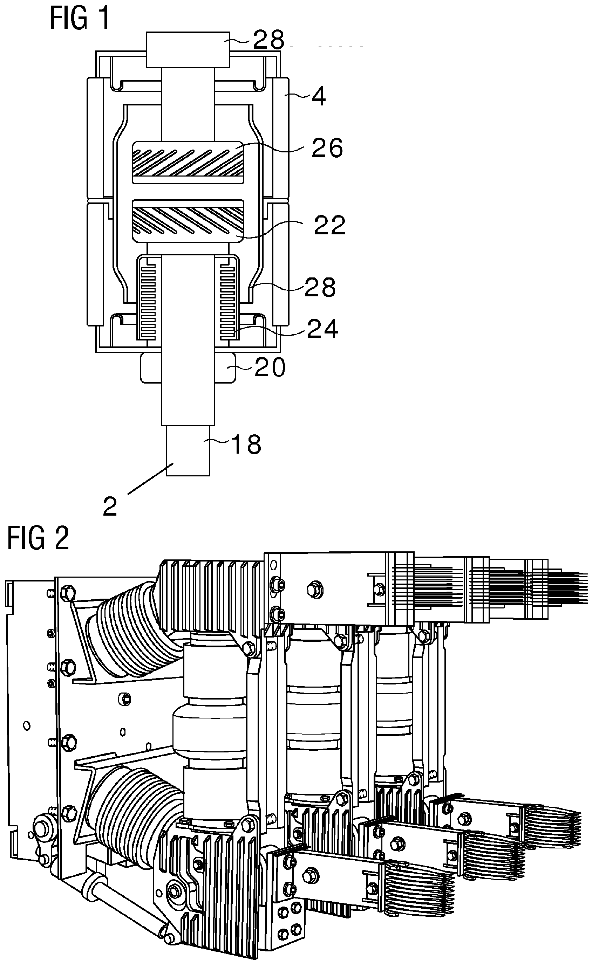

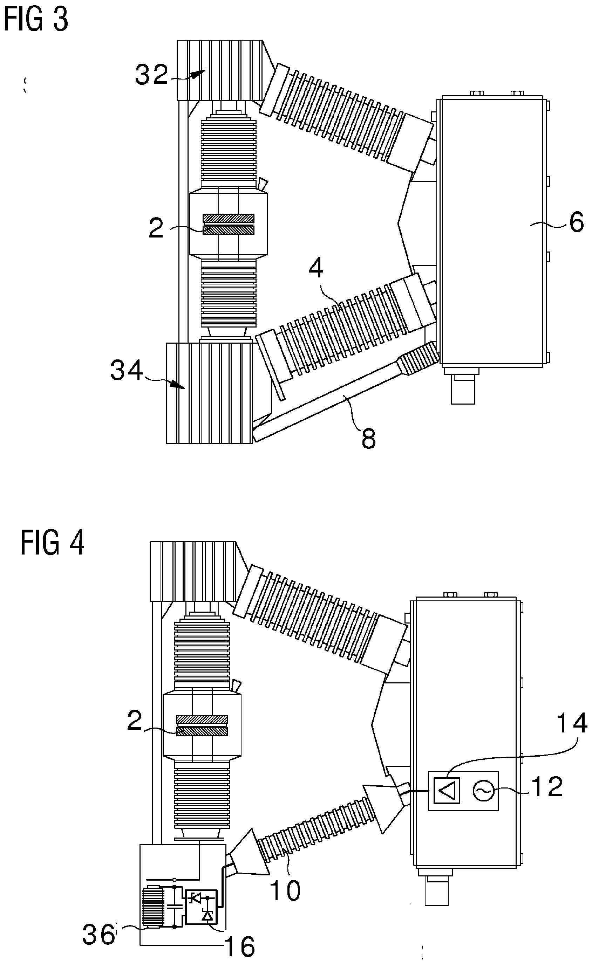

Nachfolgend werden die Erfindung und weitere Vorteile ausgehend von dem in den Figuren 1 bis 3 gezeigten Anordnungen gemäß dem Stand der Technik anhand des in der Figur 4 dargestellten Ausführungsbeispiels näher erläutert. Dabei zeigt die
- Figur 1: ein mittels Vakuumschaltröhren gebildetes Schaltgerät,
- Figur 2: eine typische Verwendung des Vakuumröhrenschaltgerätes als Leistungsschalter,
- Figur 3: ein Schalgerät des Leistungsschalters in Seitenansicht,
- Figur 4: ein Ausführungsbeispiel gemäß Erfindung in Seitenansicht.

In Figur 1 ist ein mittels einer Vakuumschaltröhre gebildetes Schaltgerät dargestellt. Zu erkennen ist der typische Aufbau angefangen mit einem Antriebs- und Abschlussbolzen 18 einer Führung 20 hierfür, einem bewegbaren Schaltstück 22, welches von einem Faltenbalg METALLFALTENBALG 24 umgeben in einer von einem Isolator ummantelten Schaltkammer 30 gelagert ist, in der auch ein feststehendes Schaltstück 26 dem beweglichen gegenüber gelagert ist und in einer Anschlussscheibe 28 seinen Abschluss findet.

In der Figur 2 sind mehrere der in der vorherigen Figur dargestellten Schaltgeräte in einer Leistungsschalteranordnung verbaut dargestellt. Hier ist im linken Teil der Darstellung auch der Hebel zu erkennen, der den Antriebs- und Anschlussbolzen im Rahmen eines Schaltvorgangs bewegt und die beiden Schaltstücke zusammenführt oder trennt und somit den Schaltkreis schließt oder öffnet.

Um die Erfindung zu verdeutlichen, ist in Figur 3 eines dieser Elemente des Leistungsschalters in Seitendarstellung zu sehen. Zu erkennen ist, wie die Vakuumschaltröhre VAKUUMSCHALTRÖHRE 2 in der Leistungsschalteranordnung zwischen einem oberen und einem unteren Schaltröhrenträger 32, 34 fixiert ist, wobei diese Träger gemäß Stand der Technik jeweils über einen Isolator ISOLATOR 4 an einen Antriebskasten ANTRIEBSKASTEN 6 angeschlossen ist, welcher über einen mechanischen Schalter MECHANISCHER SCHALTER 8, wie oben dargelegt, den beweglichen Bolzen im Rahmen des Schaltvorganges bewegt.

Bei jedem oben beschriebenen Schaltvorgang wird eine nicht dargestellte Feder mechanisch ge- oder entspannt. Die Schaltvorgänge unterliegen demnach einer hohen mechanischen Belastung und verschleißen unter Umständen bei häufigen Schaltvorgängen, was die maximale Anzahl von Schaltspielen verringert. Ausgehend von der in Figur 3 gezeigten Anordnung wird in der Figur 4 daher aufgezeigt, wie ein Ausführungsbeispiel der Erfindung den Leistungsschalter erfindungsgemäß verbessert. Auf

die in der Figur 3 unverändert verbleibenden Elemente bzw. Elemente, deren Wegfall/Modifikation beschrieben wird, wird daher mit den Bezugszeichen der Figur 3 referenziert.

Die Verbesserung beruht dabei auf dem Einsatz von Hochfrequenzenergie als Aktorenergie zum Betätigen des Schalters der Vakuumschaltröhre VAKUUMSCHALTRÖHRE 2 und diese hierfür an ihn zu übertragen. Die Übertragung kann beispielsweise mittels eines dielektrischen Wellenleiters DIELEKTRISCHER WELLENLEITER 10 erfolgen. Alternativ kann die Hochfrequenzenergie auch gestrahlt oder mit einem anderen, nicht dielektrischen, Wellenleiter übertragen werden.

Der mechanische Betätiger MECHANISCHER SCHALTER 8 kann als Elektromagnet ausgeführt werden. Bei dem dargestellten Ausführungsbeispiel wird die Vakuumschaltröhre elektrisch, beispielsweise mit Hilfe eines Relais RELAIS 36, geschaltet.

Anstatt des unteren Isolators ISOLATOR 4 ist beim gezeigten Ausführungsbeispiel ein dielektrischer Wellenleiter DIELEKTRISCHER WELLENLEITER 10 angebracht, der den Vorteil hat, dass er gleichzeitig isoliert, stabilisiert und die Übertragung der für den Schaltvorgang benötigten Leistung ermöglicht. Über diesen Wellenleiter DIELEKTRISCHER WELLENLEITER 10 kann ferner eventuell entstehende Wärme abgeleitet werden. Zu erkennen ist ferner ein Signalgenerator MICROWAVE SIGNAL GENERATOR 12, der mit einem Leistungsverstärker MICROWAVE POWER AMPLIFIER 14 das benötigte HF-Leistungssignal (z.B. im Mikrowellen oder mm-Wellen-Bereich) erzeugt, welches dann am anderen Ende des dielektrischen Wellenleiters DIELEKTRISCHEN WELLENLEITERS, d.h. auf Seiten der Vakuumschaltröhre VAKUUMSCHALTRÖHRE 2, mittels einer Gleichrichtereinrichtung MICROWAVE RECTIFIER 16 gleichgerichtet und dem Relais RELAIS 36 zugeführt wird.

Dabei können als alternative Weiterbildungen für höhere HF-Leistungen mehrere Gleichrichter parallel betrieben werden. Der Gleichrichter kann aus einer oder mehreren Dioden bestehen. Bei den Dioden kann es sich um Schottky- oder andere Dioden oder aber um modifizierte Transistoren handeln. Den Halbleitern kann eine GaAs- GaN- oder sonstige Technologie zugrunde liegen.

Der Gleichrichter kann ferner vorteilhaft weitergebildet werden, in dem durch entsprechende schaltungstechnische Maßnahmen zwischengepuffert oder stabilisiert wird. Beispielsweise kann die Gleichstromleistung in einer Kapazität zwischengespeichert und dann dem Betätiger, hier also dem Relais RELAIS 36, zum Betätigen des Vakuumschalters VAKUMMSCHALTRÖHRE 2 zur Verfügung gestellt werden.

Vorteilhafte Ausgestaltungen des Wellenleiters sind gegeben, wenn er aus Aluminiumoxid, Teflon, HD-PE oder einem anderen festen dielektrischen Material besteht. Für eine hohe Wärmeleitfähigkeit zum Zweck der Wärmeableitung kann man auch heißgepresstes Siliciumcarbid (SiC, εᵣ=40, Wärmeleitfähigkeit 90-160 W cm⁻¹ K⁻¹ ⇔ Cu 240-380 W cm⁻¹ K⁻¹) in Betracht ziehen. Außerdem kann der Wellenleiter derart ausgestaltet sein, dass er aus einem Schlauch besteht, der mit einer entsprechenden dielektrischen Flüssigkeit gefüllt ist. Dabei kann der Wellenleiter gerade sein oder auch komplexe Formen, die mit einem beliebigen heute bekannten Herstellungsverfahren produziert werden, annehmen.

Das komplette Aggregat kann vergossen werden, was ein Vorteil gegenüber Schaltgestängen sein kann. Weitere Vorteile hierdurch können das Vermeiden von Überschlägen, eine klimatische Kapselung oder eine verbesserte Entwärmung sein.

Innerhalb des Aggregats können eine oder mehrere Röhren parallel betrieben werden, was beispielsweise zu wirtschaftlichen Vorteilen führen kann. Erleichtert wird der parallele oder serielle Betrieb durch die Möglichkeit, mit einfachen elektromechanischen Maßnahmen ein hohes Maß an Schaltsynchronität zu erzielen. Diese Schaltsynchronität kann dadurch erreicht werden, dass ein geeignetes Triggersignal über das hochfrequente die Energie übertragende Signal überlagert werden kann.

Der mechanische Betätiger MECHANISCHER SCHALTER 8 oder andere Teile an der Schaltröhre oder der Gesamtanordnung können mit Sensoren ausgestattet sein, die relevante Betriebsinformationen messen. Die Information kann während der Leistungsübertragung gleichzeitig über den Wellenleiter DIELEKTRISCHER WELLENLEITER 10 zurück übertragen werden. Ebenfalls denkbar sind andere Formen der Energiekonversion ohne Gleichrichter zum Betätigen des Schalters. Beispielsweise ist ein Betrieb vorstellbar, in dem die HF-Energie dazu verwendet wird, ein Gasvolumen zu erwärmen. Dieses dehnt sich aufgrund der Erwärmung aus und treibt damit einen mit der Röhre verbundenen Kolben an. Dies ermöglicht einen langsamen Schaltvorgang. Anstatt des Gases ist außerdem der Einsatz von Wasser denkbar, welches durch die HF-Energie erwärmt wird, verdampft wird und so einen Kolben antreibt.

## Patentansprüche

1. Anordnung zum Schalten von Schaltstrecken mittels Schaltgeräten, derart ausgestaltet, dass durch eine galvanisch getrennte Energieübertragung von Hochfrequenzenergie eine Aktorenenergie für mindestens eine Vakuumschaltröhre (2), bereitgestellt wird, wobei zur Energieübertragung das Schaltgerät mechanisch nicht-leitend über einen in Richtung der Schaltstrecke der Vakuumschaltröhre als Isolator (4) angeordneten dielektrischen Wellenleiter (10), mit der Hochfrequenzquelle verbunden ist, wobei das Schaltgerät derart ausgestaltet ist, dass es Mittel aufweist, die die übertragene Energie in Aktorenenergie konvertieren, wobei die Konvertierungsmittel als mindestens eine Gleichrichteranordnung (16) ausgestaltet sind und wobei der Energieübertragung als Aktoren elektrisch betriebene Schalter, insbesondere Relaisschalter, nachgeschaltet sind.

2. Anordnung nach einem der vorhergehenden Ansprüche, **dadurch gekennzeichnet, dass** sie derart ausgestaltet ist, dass zur Energieübertragung Abstrahlen der Hochfrequenzenergie als elektromagnetische Wellen an das Schaltgerät erfolgt, wobei das Schaltgerät derart ausgestaltet ist, dass es Mittel aufweist, die die übertragene Energie in Aktorenenergie konvertieren.

3. Anordnung nach einem der Ansprüche 1 bis 2, **dadurch gekennzeichnet, dass** die Konvertierungsmittels aus zumindest zwei parallelen Gleichrichteranordnungen gebildet werden.

4. Anordnung nach einem der Ansprüche 1 bis 3, **dadurch gekennzeichnet, dass** der Wellenleiter (10) aus einem festem dielektrischen Material, insbesondere Aluminiumoxid, Teflon, HD-PE oder heißgepresstem Siliciumcarbid, besteht.

5. Anordnung nach einem der Ansprüche 1 bis 3, **dadurch gekennzeichnet, dass** der Wellenleiter (10) aus einem flexiblen mit dielektrischen Flüssigkeiten gefüllten Material gebildet ist.

6. Anordnung nach einem der vorhergehenden Ansprüche, **dadurch gekennzeichnet, dass** zumindest Teile der Elemente der Schaltanordnung mit Sensoren versehen sind.

## Claims

1. Arrangement for switching open contact gaps by means of switching devices, configured in such a manner that DC-isolated energy transmission of radio-frequency energy provides actuator energy for at least one vacuum interrupter (2), the switching device being mechanically connected to the radio-frequency source in a nonconductive manner via a dielectric waveguide (12) arranged in the direction of the open contact gap of the vacuum interrupter as insulator for the purpose of energy transmission, the switching device being configured in such a manner that it has means which convert the transmitted energy into actuator energy, the conversion means being in the form of at least one rectifier arrangement (16) and electrically operated switches, in particular relay switches, being connected downstream of the energy transmission as actuators.

2. Arrangement according to the preceding claim, **characterized in that** it is configured in such a manner that, for the purpose of transmitting energy, the radio-frequency energy is emitted as electromagnetic waves to the switching device, the switching device being configured in such a manner that it has means which convert the transmitted energy into actuator energy.

3. Arrangement according to one of Claims 1 to 2, **characterized in that** the conversion means are formed from at least two parallel rectifier arrangements.

4. Arrangement according to one of Claims 1 to 3, **characterized in that** the waveguide (10) consists of a solid dielectric material, in particular aluminum oxide, Teflon, HDPE or hot-pressed silicon carbide.

5. Arrangement according to one of Claims 1 to 3, **characterized in that** the waveguide (10) is formed from a flexible material filled with dielectric liquids.

6. Arrangement according to one of the preceding claims, **characterized in that** at least parts of the elements of the switching arrangement are provided with sensors.

## Revendications

1. Système pour commuter des trajets de commutation au moyen d'appareils de commutation, réalisé de telle sorte qu'une énergie d'actionneurs est fournie pour au moins un tube de commutation à vide (2) par une transmission d'énergie haute fréquence à séparation galvanique, l'appareil de commutation, aux fins de la transmission d'énergie, étant relié mécaniquement et de manière non conductrice à la source haute fréquence via un guide d'ondes diélectrique (10) agencé dans le sens du trajet de commutation du tube de commutation à vide en tant qu'isolant (4), l'appareil de commutation étant conçu de telle sorte qu'il comporte des moyens qui convertissent l'énergie transmise en énergie d'actionneurs, les moyens de conversion étant conçus en tant qu'au moins un dispositif redresseur (16) et des commutateurs électriques, et plus particulièrement des commutateurs relais, étant montés, en tant qu'actionneurs, en aval de la transmission d'énergie.

2. Système selon l'une des revendications précédentes, **caractérisé en ce qu'**il est conçu de telle sorte que, pour la transmission d'énergie, l'énergie haute fréquence est rayonnée en tant qu'ondes électromagnétiques vers l'appareil de commutation, l'appareil de commutation étant conçu de telle sorte qu'il comporte des moyens qui convertissent l'énergie transmise en énergie d'actionneurs.

3. Système selon l'une des revendications 1 à 2, **caractérisé en ce que** les moyens de conversion sont formés par au moins deux dispositifs redresseurs parallèles.

4. Système selon l'une des revendications 1 à 3, **caractérisé en ce que** le guide d'ondes (10) se compose d'un matériau diélectrique, et plus particulièrement d'oxyde d'aluminium, de téflon, de HD-PE ou de carbure de silicium pressé à chaud.

5. Système selon l'une des revendications 1 à 3, **caractérisé en ce que** le guide d'ondes (10) est formé par un matériau souple rempli de liquides diélectriques.

6. Système selon l'une des revendications précédentes, **caractérisé en ce qu'**au moins des parties des éléments du système de commutation sont prévues avec des capteurs.
